# EUROPÄISCHE PATENTANMELDUNG

(11) **EP 1 595 972 A1**
(43) Veröffentlichungstag der Anmeldung: **16.11.2005**
(21) Anmeldenummer: 04405299.1
(22) Anmeldetag: 10.05.2004
(51) Int. Cl.: C23C 14/48

(54) **Verfahren zum Bearbeiten von metallischen Körpern, insbesondere von Uhrenbestandteilen**

(71) Anmelder: Precision Engineering AG, 8200 Schaffhausen (CH)
(72) Erfinder: Lange, Jürgen R., CH-8200 Schaffhausen (CH)
(74) Vertreter: Dr. Graf & Partner

(57) **Zusammenfassung**

Bei einem aus einem vergleichsweise weichen Material, z.B. Messing oder Gold, bestehenden Zahnrad (2) eines Getriebes für eine Uhr wird die Oberflächenhärte der Flanken (3) der Zähne (4) mittels Ionenimplantation um ein Mehrfaches erhöht. Damit wird die Verschleissfestigkeit der mechanisch beanspruchten Zahnradflanken (3) erheblich verbessert, ohne dass die ursprüngliche Oberflächenqualität und die Massgenauigkeit des Zahnrades (2) beeinträchtigt wird. Die ursprünglich Oberflächenhärte der übrigen Flächen des Zahnrades (2) wird dabei nicht verändert.

## Beschreibung

Die Erfindung betrifft ein Verfahren zum Bearbeiten von metallischen Körpern, die funktionell und/oder ästhetisch wirkende, einer Abnützung unterworfene Flächen aufweisen, gemäss Oberbegriff des Anspruches 1, sowie einen metallischen Körper gemäss Oberbegriff des Anspruches 8.

Bei bewegten Uhrenbestandteilen, wie z.B. Zahnrädern, die mit Funktionsflächen im Eingriff mit andern Uhrenbestandteilen bzw. deren Funktionsflächen stehen, sind diese Funktionsflächen einer mechanischen Beanspruchung ausgesetzt und damit einer gewissen Abnützung unterworfen. Daneben gibt es auch andere metallische Körper, z.B. Schmuckstücke, die ästhetisch wirkende Flächen aufweisen, die einer gewissen Abnützung zum Beispiel in Form der Verschlechterung ihrer ästhetischen Wirkung unterworfen sind.

Der vorliegenden Erfindung liegt nun die Aufgabe zugrunde, ein Verfahren der eingangs genannten Art zu schaffen, mit dem auf kostengünstige Weise die Verschleissfestigkeit der Oberfläche von einer Abnützung unterworfenen, ästhetisch und/oder funktionell wirkenden Flächen von fertigen metallischen Körpern verbessert werden kann, ohne dass die Oberflächenqualität dieser Flächen oder die Massgenauigkeit beeinträchtigt wird.

Mit dieser Erfindung wird insbesondere auch bezweckt, ein Verfahren zu schaffen, mit dem auf kostengünstige Weise die Verschleissfestigkeit der Oberfläche von Funktionsflächen von fertigen Uhrenbestandteilen verbessert werden kann, ohne dass die Oberflächenqualität dieser Funktionsflächen oder die Massgenauigkeit beeinträchtigt wird.

Diese Aufgabe wird erfindungsgemäss durch ein Verfahren mit den Merkmalen des Anspruches 1 gelöst. Ein nach diesem Verfahren behandelter Körper weist die Merkmale des Anspruches 8 auf.

Durch Ionenimplantation wird die Oberflächenhärte einer, einer Abnützung unterworfenen Fläche, in ihrem ganzen Bereich oder nur in einem Teilbereich wesentlich erhöht. Vorzugsweise wird dabei die Härte der oberflächennahen Schicht wesentlich erhöht, wobei diese Schicht beispielsweise eine Schichtdicke von einigen µm aufweist. Da dabei kein Materialauftrag erfolgt, wird die ursprüngliche Massgenauigkeit und auch die Oberflächenqualität durch die Ionenimplantation nicht beeinflusst. Letzteres ist beispielsweise bei Körpern von Bedeutung, deren Flächen herstellungsbedingt sehr glatt sind, insbesondere bei Uhrenbestandteilen, die im LIGA-Verfahren hergestellt wurden. Dieses Verfahren wird auf Deutsch beispielsweise auch als "Lithographie, Galvanoformung, Abformung" bezeichnet, und auf Englisch als "LIGA-Technology" bezeichnet.

Durch die erfindungsgemässe Bearbeitung gewisser Flächen mittels Ionenimplantation wird auch die Korrosionsbeständigkeit dieser Flächen nicht negativ beeinflusst. Diejenigen Bereiche der Flanken, die durch Ionenimplantation bearbeitet wurden, unterscheiden sich optisch praktisch nicht von den unbearbeiteten Flächenbereichen.

Das Ionenimplantationsverfahren erlaubt auch ein Verbessern der Oberflächenhärte selektiv nur an ausgewählten Funktionsflächen. So können z.B. an einem Uhrenbestandteil nach seiner Herstellung je nach Bedarf nur in diejenigen Funktionsflächen Ionen implantiert werden, bei denen eine Erhöhung der Oberflächenhärte tatsächlich erforderlich ist, während bei den übrigen Funktionsflächen auf eine Ionenimplantation und damit auf eine Erhöhung der Oberflächenhärte verzichtet wird. Dasselbe trifft z.B. auch auf Schmuckstücke zu, bei denen nur bei denjenigen Flächen die Oberflächenhärte erhöht wird, bei denen die Erhaltung der ästhetischen Wirkung gewünscht wird.

Zur Erhöhung der Oberflächenhärte sind für die Ionenimplantation generell die für ein Härteverfahren geeigneten Ionen verwendbar, beispielsweise Be-Ionen.

Bevorzugte Weiterausgestaltungen des erfindungsgemässen Verfahrens bzw. des erfindungsgemässen Körpers bilden Gegenstand der abhängigen Ansprüche.

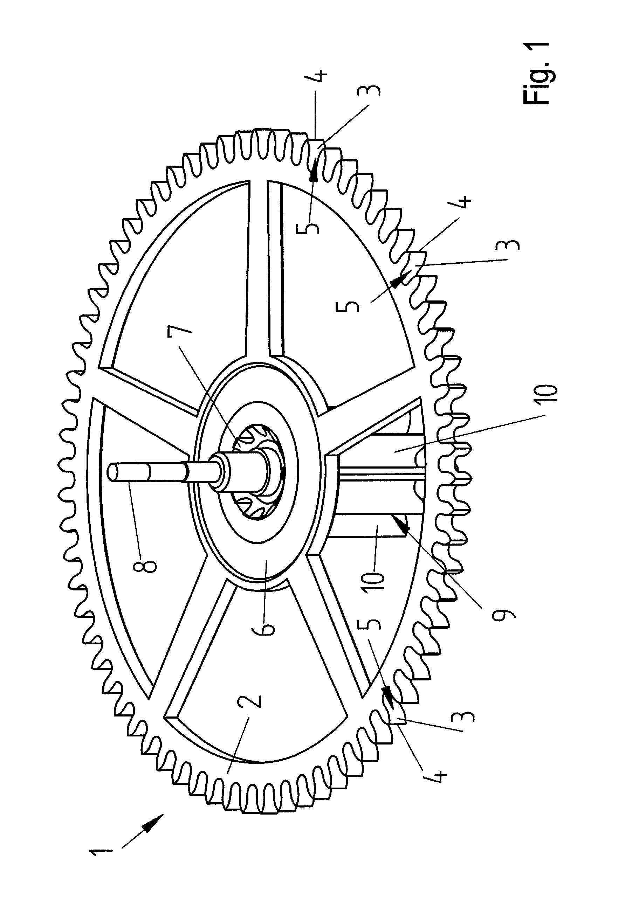

Im folgenden wird die Erfindung anhand einer Zeichnung, welche lediglich ein Ausführungsbeispiel darstellt, näher erläutert. Die einzige Figur zeigt in einer perspektivischen Darstellung ein auf eine Antriebswelle aufgenietetes oder aufgepresstes Zahnrad eines Getriebes für eine Uhr.

In der Figur ist als ein Beispiel eines nach dem erfindungsgemässen Verfahren bearbeiteten metallischen Körpers dargestellt, nämlich ein Uhrenbestandteil 1 in der Form eines Zahnrades 2 eines Getriebes. Die Flanken 3 der Zähne 4 des Zahnrades 2 bilden Funktionsflächen 5, die mit andern Uhrenbestandteilen bzw. deren Funktionsflächen in Eingriff kommen, z.B. mit den Zahnflanken anderer Zahnräder oder mit den Funktionsflächen von Schalt- oder Sperrklinken. Diese Funktionsflächen 5 sind somit einer mechanischen Beanspruchung unterworfen und daher einem Verschleiss ausgesetzt.

Um die Verschleissfestigkeit der Funktionsflächen 5 zu verbessern, ist die Härte deren Oberfläche mittels des an sich bekannten Ionenimplantationsverfahrens erhöht worden. Bei der Ionenimplantation werden Ionen, z.B. Be-Ionen in die Oberfläche der Zahnflanken 3 eingeschossen, die im oberflächennahen Bereich eingebaut werden, wodurch eine Erhöhung der Härte der Oberfläche bewirkt wird.

Es ist möglich, die Oberflächenhärte jeweils der gesamten Funktionsfläche 5 oder nur eines Teilbereichs derselben auf die erwähnte Weise zu erhöhen. Im weitern können alle Funktionsflächen 5 eines Uhrenbestandteils 1 oder nur ein Teil dieser Funktionsflächen 5 mittels Ionenimplantation bearbeitet werden.

Da bei der Ionenimplantation keine Schicht auf die Oberfläche der Funktionsflächen aufgetragen wird, bleibt die ursprüngliche Qualität dieser Oberfläche praktisch erhalten. Zudem wird die vorhandene Massgenauigkeit nicht beeinträchtigt. Dies ist vor allem dann von grossem Vorteil, wenn - wie das beim gezeigten Ausführungsbeispiel der Fall ist - der Uhrenbestandteil 1 mittels des sogenannten LIGA-Verfahrens hergestellt worden ist, da die Funktionsflächen 5, d.h. die Zahnflanken 3, eines solchen Uhrenbestandteils 1 eine qualitativ hochstehende, d.h. eine sehr glatte Oberfläche aufweisen, deren Qualität durch die Bearbeitung mittels Ionenimplantation nicht signifikant verändert wird. Die Korrosionsbeständigkeit der erfindungsgemäss bearbeiteten Funktionsflächen 5 wird durch die Ionenimplantation ebenfalls nicht negativ beeinflusst.

Beim vorliegenden Ausführungsbeispiel ist das Zahnrad 2 mit einer Nabe 6 auf einen Radansatz 7 des aussen verzahnten Triebs 9 aufgenietet oder aufgepresst, der mit einer Welle 8 fest verbunden ist. Die Oberflächenhärte der Zahnflanken 10 des Triebes 9 kann bei Bedarf ebenfalls mittels Ionenimplantation erhöht worden sein.

Das in der Figur gezeigte Zahnrad 2 ist aus einem vergleichsweise weichen Material, insbesondere aus Gold oder aus einer Goldlegierung, hergestellt. Das hat den Vorteil, dass sich das Zahnrad 2 mit seiner Nabe 6 verhältnismässig leicht auf den Radansatz 7 aufbringen lässt. Dabei kann die Aussenverzahnung des Radansatzes 7 in das weichere Material der Nabe 6 eindringen, um so einen festen Sitz des Zahnrades 2 auf dem Radansatz 7 zu erhalten. Die sich aus der Wahl eines vergleichsweise weichen Materials für das Zahnrad 2 ergebenden verschleisstechnischen Nachteile sind dadurch behoben, dass wie erwähnt die Oberflächenhärte der mechanisch beanspruchten Zahnflanken 3 des Zahnrades 2 mittels Ionenimplantation erhöht worden ist, und zwar um einen Faktor 2 oder mehr. So konnte beispielsweise bei einem Zahnrad 2 aus Gold durch Eintragen von Berylliumionen mittels Ionenimplantation die Oberflächenhärte der Zahnflanken 3 von HV200 auf HV400 und mehr erhöht werden. Der Vorteil einer Erhöhung der Oberflächenhärte der mechanisch beanspruchten Zahnflanken 3 des Zahnrades 2 ist somit kombiniert mit einer leichten Montage des Zahnrades 2.

Der Uhrenbestandteil 1 kann statt aus Gold oder einer Goldlegierung auch aus einem andern Metall oder einer Legierung aus Metallen hergestellt werden, z.B. aus Platin, Silber, Messing, Nickel, Stahl oder dgl.

Die nach dem erfindungsgemässen Verfahren zu bearbeitenden Uhrenbestandteile 1 können auch auf andere Weise als mittels des LIGA-Verfahrens hergestellt werden, z.B. durch ein geeignetes Material auftragendes Verfahren, ein Material abtragendes Verfahren oder ein Material verdichtendes Verfahren, wie z.B. durch Stanzen, Drehen, Fräsen, Drahterodieren, Rollieren oder ähnliche Fertigungsverfahren.

Ausser bei Zahnrädern für Rädergetriebe lässt sich auf die erfindungsgemässe Weise auch bei andere Arten von Uhrenbestandteilen die Oberflächenhärte von Funktionsflächen erhöhen, so z.B. bei Sperr- oder Schaltklinken von Sperrwerken und Schaltgetrieben, Hebeln, Rollen, Führungskulissen, Ankerrädern, Ankern, Wellenzapfen und dgl.

Ausser Uhrenbestandteilen lassen sich mit dem erfindungsgemässen und vorstehend beschriebenen Verfahren auch Teile oder Körper für andere Anwendungsgebiete herstellen, die eine rein optische, ästhetische Funktion zu erfüllen haben, z.B. Schmuckstücke und Teile hiervon.

Solche in der Schmuckindustrie verwendeten Teile oder Körper haben herstellungsbedingt glatte, z.B. polierte, Flächen, mit denen ein gewünschter optischer, ästhetischer Effekt erzielt werden soll, die aber im Gebrauch einer Abnutzung ausgesetzt sind. Auf die erfindungsgemässe Weise lässt sich die Oberflächenhärte solcher Flächen und damit die Resistenz gegen z.B. Zerkratzen gezielt erhöhen. Es ist nicht nötig, den gesamten Körper einer Härtung zu unterziehen.

## Patentansprüche

1. Verfahren zum Bearbeiten von metallischen Körpern (1), die funktionell und/oder ästhetisch wirkende, einer Abnützung unterworfene Flächen (5) aufweisen, **dadurch gekennzeichnet, dass** bei wenigstens einem Teil der einer Abnützung unterworfenen Flächen (5) eines Körpers (1) die Oberflächenhärte jeweils der gesamten Fläche (5) oder eines Teils derselben mittels Ionenimplantation erhöht wird.

2. Verfahren nach Anspruch 1 zum Bearbeiten von metallischen Uhrenbestandteilen (1), deren einer Abnützung unterworfene Flächen als Funktionsflächen (5) ausgebildet sind, die mit andern Uhrenbestandteilen in Berührung kommen, wobei bei wenigstens einem Teil der mechanisch beanspruchten Funktionsflächen (5) die Oberflächenhärte jeweils der gesamten Funktionsfläche (5) oder eines Teils derselben mittels Ionenimplantation erhöht wird.

3. Verfahren nach Anspruch 1 oder 2, **dadurch gekennzeichnet, dass** die Härte der glatten Oberfläche von Flächen (5) bei einem Körper (1) erhöht wird, der mittels eines Material deponierenden Verfahrens hergestellt ist.

4. Verfahren nach Anspruch 2, **dadurch gekennzeichnet, dass** die Härte der glatten Oberfläche von Funktionsflächen (5) bei einem mittels des LIGA-Verfahrens hergestellten Uhrenbestandteil (1) erhöht wird.

5. Verfahren nach Anspruch 1 oder 2, **dadurch gekennzeichnet, dass** die Härte der Oberfläche von Flächen (5) bei einem Körper (1) erhöht wird, der durch ein Material abtragendes oder ein Material verdichtendes Verfahren hergestellt ist.

6. Verfahren nach Anspruch 2, **dadurch gekennzeichnet, dass** die Härte der Oberfläche von Funktionsflächen (5) bei einem durch Stanzen hergestellten Uhrenbestandteil (1) erhöht wird.

7. Verfahren nach einem der Ansprüche 1 bis 6, **dadurch gekennzeichnet, dass** die Körper (1) aus einem Edelmetall, vorzugsweise aus Gold oder einer Goldlegierung, oder aus Nickel, Stahl oder Messing hergestellt werden.

8. Metallischer Körper (1) mit funktionell und/oder ästhetisch wirkenden, einer Abnützung unterworfenen Flächen (5), insbesondere hergestellt nach dem Verfahren gemäss Anspruch 1, **dadurch gekennzeichnet, dass** bei wenigstens einem Teil der einer Abnützung unterworfenen Flächen (5) die Oberflächenhärte jeweils der ganzen Fläche (5) oder eines Teils derselben durch Ionenimplantation erhöht ist.

9. Metallischer Körper nach Anspruch 8, **dadurch gekennzeichnet, dass** er ein Uhrenbestandteil (1) ist, dessen einer Abnützung unterworfenen Flächen als mechanisch beanspruchte Funktionsflächen (5) ausgebildet sind, die mit andern Uhrenbestandteilen in Berührung kommen, wobei bei wenigstens einem Teil der mechanisch beanspruchten Funktionsflächen (5) die Oberflächenhärte jeweils der ganzen Funktionsfläche (5) oder eines Teils derselben durch Ionenimplantation erhöht ist.

10. Körper nach Anspruch 8 oder 9, **dadurch gekennzeichnet, dass** er mittels eines Material deponierenden Verfahrens hergestellt ist.

11. Körper nach Anspruch 9, **dadurch gekennzeichnet, dass** er ein mittels des LIGA-Verfahrens hergestellter und glatte Funktionsflächen (5) aufweisendender Uhrenbestandteil (1) ist.

12. Körper nach Anspruch 8 oder 9, **dadurch gekennzeichnet, dass** er mittels eines Material abtragenden oder eines Material verdichtenden Verfahrens hergestellt ist.

13. Körper nach Anspruch 9, **dadurch gekennzeichnet, dass** er ein durch Stanzen hergestellter Uhrenbestandteil (1) ist.

14. Körper nach einem der Ansprüche 8 bis 13, **dadurch gekennzeichnet, dass** er aus einem Edelmetall, vorzugsweise aus Gold oder einer Goldlegierung, oder aus Nickel, Stahl oder Messing hergestellt ist.
